# EUROPEAN PATENT SPECIFICATION

(11) **EP 1 421 838 B1**
(45) Date of publication and mention of the grant of the patent: **12.01.2005**
(21) Application number: 02739256.2
(22) Date of filing: 13.05.2002
(51) Int. Cl.: H05K 9/00

(54) **METHOD FOR FORMING ELECTRICALLY CONDUCTIVE IMPREGNATED FIBERS AND FIBER PELLETS**
VERFAHREN ZUR HERSTELLUNG VON IMPRÄGNIERTEN ELEKTRISCHEN STROMLEITENDEN FASERN UND FASERTEILCHEN
PROCEDE DE FORMATION DE FIBRES ET DE GRANULES DE FIBRES IMPREGNEES, CONDUISANT L'ELECTRICITE

(30) Priority: 31.08.2001 US 943677
(43) Date of publication of application: 26.05.2004
(73) Proprietor: Parker Hannifin Corporation, Cleveland, OH 44124-4141 (US)
(72) Inventor: COFER, Cameron G,, Gahanna, OH 43230 (US); MCCOY, Dale E,, Granville, OH 43023 (US)
(74) Representative: Pilch, Adam John Michael
(86) International application number: PCT/US2002/015167
(87) International publication number: WO 2003/022026

(56) References cited:
- EP-A- 1 096 077
- GB-A- 1 015 373
- US-A- 3 958 066
- US-A- 4 539 433

## Description

### Field of the Invention

The present invention relates to electrically conductive impregnated fibers and their method of manufacture. More particularly, the invention relates to a method for forming electrically conductive fibers by impregnating conductive fibers with an organic wetting agent to form an impregnated fiber tow and subsequently sheathed. Such sheathed impregnated tows can be formed into a wide variety of products such as radio-frequency and electromagnetic shielded plastic articles.

### Background of the Invention

With the increased usage of electronic equipment such as computers and other digital devices there is a heightened concern for the hazards associated with electromagnetic radiation, in particular radar waves, microwaves and electromagnetic radiation produced by electronic circuits. As the electronic industry continues to grow at a rapid pace, there exists a need to create improved electromagnetic wave shielding materials, which can be incorporated into electronic products.

Over the years, a number of electrically conductive materials have been developed to fabricate composite articles, such as plastic articles, for electro-magnetic shielding, electrostatic dissipation, and other electrically enhanced characteristics. Plastic articles formed from electrically conductive materials are particularly convenient as compared to traditional metal materials because they are lightweight, easily produced using injection molding techniques, and low cost. Typically these electrically conductive materials are composites of plastics and conductive powders and cut fibers.

Various techniques have been employed when incorporating electrically conductive powders and chopped fibers into a composite article. FIG. illustrates a traditional thermoplastic extrusion compounding technique, which has been commonly employed (generally called compounding). In this method, a thermoplastic resin 12 is fed into the compounder 10. The resin 12 is heated to a molten temperature and then fibers or powders (collectively indicated as 14) are fed into the compounder 10. The mixture is kneaded to mix in the conductive powders or chopped fibers. Unfortunately, when kneading conductive fibers with a molten thermoplastic, the fibers are often broken due to the cutting action by the kneading screw 16 and by the shearing of the resin.

These fibers are broken into smaller and smaller segments such that the resulting composite article contains only shorter length broken fibers. Such shortened fibers impart reduced electromagnetic shielding properties to the composite due to their reduced ability to form a conductive fiber network and conduct electricity through the composite article. Alternatively, when mixing conductive powders with the molten thermoplastic it is typically necessary to employ a very large amount of the conductive powder. Such large amounts of powder can result in a poor dispersion of the powder or reduced mechanical strength of the final product. Accordingly, composite articles formed with broken fibers and powders require higher loadings or filler concentrations lead to an embrittlement of the composite article formed and higher material costs. The resin/broken fiber mixture is extruded 18, cooled in a water bath 20, then chopped by a Strand Cutter 22 into pellets 24.

In an alternate approach, chopped conductive fibers are mixed with the resin directly at the injection molding operation. However, this typically results in very poor fiber dispersion and inconsistent electrical performance from part to part, Furthermore, operators working directly with the chopped fibers and powders can experience skin irritation when handling the materials.

To avoid the problems with directly mixing in cut fibers and powders, attempts have been made to provide electromagnetic wave shielding pellets by coating an electrically conductive fiber with a synthetic resin and then cutting the coated fiber into pellet form. Typically, such a process involves the use of continuous lengths of filaments, which are passed through a bath containing a molten resin whereby such filaments become impregnated with the resin. Once the filaments are impregnated they are continuously withdrawn from the bath, commingled either before or after passage through a heat source and cooled to solidify the molten resin around the fibers. These impregnated fibers are then cut to form pellets, which are then formed into composite articles. Unfortunately, this direct impregnation process is very slow, and the impregnated fibers may fray when cut into pellets and can become separated from the resin.

Another method employed in the formation of electromagnetic shielded articles is the coating of electrically conductive fibers with a coupling agent followed by coating the coated fibers with a synthetic resin layer. For example, titanate coupling agents, as generally described in U.S. Patent 4,530,779, have been employed as the initial coating agent for the electrically conductive fibers. Similarly, other attempts at forming electromagnetic shielded articles have passed electrically conductive fibers through a bath of a polymeric material to first impregnate the fibers. These impregnated fibers are then sheathed with a second polymeric material. As generally described in U.S. Patent 4,664,971 and 5,397,608, when forming a composite article, an electrically conductive fiber may be impregnated and sheathed to provide a more even distribution of the conductive fibers, under minimal shear force and without substantial fiber breakage. Yet, as generally described by U.S. Patent 4,960,642, another method of forming impregnated and sheathed fibers involves the extrusion of an impregnating resin onto the fiber and then extruding a second resin onto the impregnated fiber.

Previous methods of impregnating and sheathing conductive fibers have not been entirely satisfactory for uniformly impregnating conductive fibers from a bath to form an impregnated tow having a high level of organic coating agent.

Additionally, as described in WO 98/06551, a chemical treatment may be applied to fibers, such as reinforcing fibers suitable for making a composite article, so as to size and/or impregnate the fibers. Composite strands of WO 98/06551 may be used to form fiber-reinforced thermoplastic conductive articles.

### Summary of the Invention

The invention answers the problems connected with previous methods of forming impregnated conductive tows by impregnating electrically conductive fibers in a bath of an organic wetting agent. These impregnated tows are suitable for a variety of uses such as the formation of composite articles having electromagnetic shielding properties. In particular, by employing high levels of an impregnating organic wetting agent in the fiber tows, pellets formed from the inventive tows are capable of achieving a more uniform dispersion of the conductive fibers when formed into a composite article. Moreover, the inventive composites, having a more uniform dispersion of conductive fibers, are capable of exhibiting improved electromagnetic shielding properties.

More specifically, the invention provides impregnated tows of electrically conductive fibers and their method of formation. Generally, the method for forming electrically conductive impregnated fibers of the invention involves feeding out electrically conductive fibers into a bath containing an organic wetting agent and impregnating the fibers with the organic wetting agent to form an impregnated fiber tow. In the bath, the organic wetting agent is applied such that the wetting agent is at least ten (10) percent by weight of the resulting impregnated fiber tow. Once impregnated, a thermoplastic or thermoset sheath is then placed onto the impregnated fiber tow, The resulting sheathed, impregnated tow can then be cut into pellets or rolled up into a package.

In a preferred embodiment of the invention, an electrically conductive impregnated fiber pellet is formed by pulling the electrically conductive fibers through a bath containing an aqueous emulsion of about thirty-five (35) to about sixty-five (65) weight percent wax such that the wax impregnates the conductive fibers and forms an impregnated tow. It is preferred that the impregnated tow contains wax in an amount ranging from about ten (10) to about thirty (30) percent by weight of the resulting impregnated fiber tow. Having impregnated the tow with wax, a thermoplastic or thermoset is placed on the impregnated tow to form a sheath.

### Brief Description of the Drawings

The accompanying drawings, which are included to provide further understanding of the invention and are incorporated in and constitute a part of this specification, illustrate embodiments of the invention and together with the description serve to explain the principle of the invention. In the drawings:

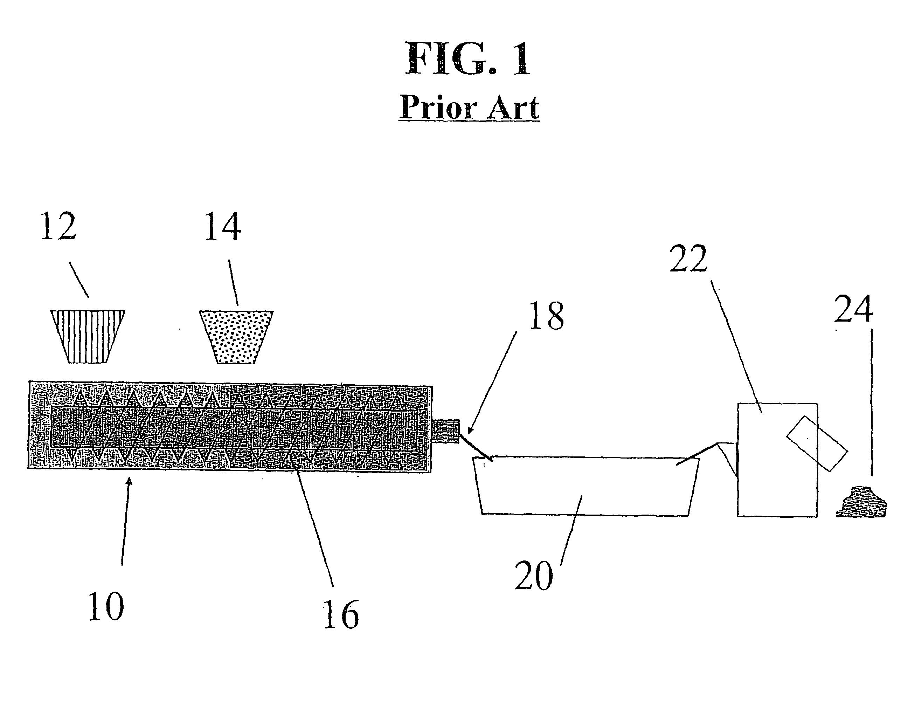

FIG. 1 is a schematic representation of a prior art thermoplastic extrusion compounding
FIGS. 2a and 2b are schematic representations illustrating a method for forming impregnated tows of electrically conductive fibers according to the present invention, off-line and in-line, respectively; and
FIG. 3 is a graph illustrating the improved EMI far field shielding performance obtained by articles having fibers formed according to the present invention
FIG. 4 is a graph illustrating the improved EMI near field shielding performance obtained by articles having fibers formed according to the present invention
FIG. 5 is a graph illustrating the improved EMI shielding performance obtained with thermoplastic molded articles having fibers formed according to the present invention as compared with articles having conventional fibers, in which the fibers and resin are combined by dry blending.
FIG. 6A represents an x-ray image of fibers dry-blended with resin and then injection molded, such fibers not being pre-impregnated.
FIG. 6B represents an x-ray image injection molded of pre-impregnated fibers, but without optimized sizing.
FIG. 6C represents an x-ray image of pre-impregnated fibers dry-blended with resin and then injection molded according to the present invention.

### Detailed Description of the Invention

Unless defined otherwise, all technical and scientific terms used herein have the same meaning as commonly understood by one of ordinary skill in the art to which this invention belongs. Although any methods and materials similar or equivalent to those described herein can be used in the practice or testing of the present invention, the preferred methods and materials are described herein. Reference will now be made in detail to the preferred embodiments of the present invention, examples of which are illustrated in the accompanying drawings.

The invention relates to methods of forming impregnated conductive tows by impregnating electrically conductive fibers in a bath of an organic wetting agent. By employing high levels of an impregnating organic wetting agent in the fiber tows, pellets formed from the inventive tows can provide a more uniform dispersion of the conductive fibers when formed into a composite article. In particular, composites formed with the high level organic impregnated tows of the invention are capable of exhibiting improved electromagnetic shielding properties.

It has been found that increased impregnation of the organic wetting agent improves dispersion of the electrically conductive fibers when forming a composite material. Thus, in the method of the invention it is desired to completely coat each of the electrically conductive fibers in the tow with the organic wetting agent to prewet the fibers. It is believed that when no organic wetting agent is employed, the dispersion of the fibers suffers due to surface tension holding the electrically conductive fibers together rather than allowing them to separate and disperse.

To achieve a desired amount of organic wetting agent on the impregnated tow, the impregnated tows of the invention are generally formed by feeding out electrically conductive fibers into a bath containing an organic wetting agent. In the bath the organic wetting agent is allowed to impregnate the fibers to form an impregnated fiber tow such that the wetting agent is present in an amount of at least 10 percent by weight of the resulting impregnated fiber tow. These impregnated tows are then sheathed with a sheathing material, typically a thermoplastic or thermoset sheath. The sheathed, impregnated tow may then be cut into pellets or rolled up into a package.

Through the use of the invention, pellets containing long electrically conductive fibers with improved dispersion characteristics can be formed. As a result, when a composite article is formed with the pellets of the invention, the fibers more readily disperse and form an electrically conductive network in the thermoplastic or thermoset matrix during the molding process, thereby improving the electrical characteristics of the resulting article. The invention is described in further detail below.

### Electrically Conductive Fibers

Various types of electrically conductive fibers may be employed in the invention. Generally, the electrically conductive fibers employed in the invention are metal fibers and metal coated fibers. Suitable metal fibers include, but are not limited to, copper, aluminum, silver, zinc, gold, nickel, stainless steel and alloys thereof. Suitable metal coated fibers include carbon, such as graphite, and glass fibers that are coated with a conductive metal. Generally, the metal coatings are formed from copper alloys, silver, gold, tin, nickel, aluminum, zinc and alloys thereof. The preferred electrically conductive fibers of the invention are metal coated carbon and glass fibers. It is preferred that the conductive fibers of the invention, when forming composite materials, are capable of being dispersed under sufficiently low shear forces without substantial breakage. Accordingly, preferred conductive fibers of the invention have a diameter ranging from about 2 to about 20 micrometers, more preferably about 3 to about 15, most preferably about 5 to about 10 micrometers.

The fibers of the invention may be provided from a variety of sources including a bushing of molten reinforcing material, eg., glass, or one or more spools or other packages of preformed fibers which are conductive or may be rendered conductive. For example, an in-line process may be employed in which glass fibers are continuously formed from a molten glass material. These glass fibers may then be coated with a metal via known processes, such as electroplating or chemical vapor deposition, such that conductive, metallized glass fibers are formed. Preferably, however, the electrically conductive fibers are fed off-line from a package or spool.

Additionally, it is possible to feed a mixture of conductive and nonconductive fibers to the impregnating bath to form an impregnated tow. For example, it is possible to feed a side by side configuration of conductive fibers and nonconductive fibers to the impregnating bath to form an impregnated tow.

### Application of Organic Wetting Agent

Generally, the electrically conductive fibers of the invention are fed to an impregnating bath containing an organic wetting agent. The fibers can be fed to the bath in the form of a conductive fiber tow (strand) or as individual strands. Typically, about 1,000 to about 35,000 fibers will be fed to the bath, preferably about 1,500 to about 10,000 fibers, and most preferably about 2,000 to 4,000 fibers will be fed to the bath. These electrically conductive fiber tows or strands may be pulled to and from the bath using a puller. This coating method enables all fibers within each strand to be uniformly wetted uniformly so that they will adequately disperse during the molding process. To facilitate penetration of the organic wetting agent, a breaker bar and gathering shoe may be used in conjunction with the bath.

The organic wetting agent is typically a film forming material or a coupling agent or a mixture thereof. Suitable organic wetting agents for the invention are described in WO 98/06551, the disclosure of which is herein incorporated by reference in its entirety. In a preferred embodiment of the invention, the bath containing the organic wetting agent is maintained at a viscosity of less than about 1 Pa-s and at a temperature ranging from about 93 °C to about 110 °C. More preferably, the organic wetting agent has a viscosity of about 0.3 Pa-s or less, most preferably less than about 0.05 Pa-s.

Generally, film formers for the invention are generally capable of coating the individual electrically conductive fibers to form an impregnated tow. For example, suitable film former include, but are not limited to, waxes, polyethylene glycols, polypropylene glycols, polycaprolactones, glycidyl ethers, epoxy resins, urethanes, polyester alkyds, amic acid, propylene glycol fumarate, propoxylated bisphenol-A-maleate, propoxylated allyl alcohol-maleate, polyvinyl acetates, olefins, nylon, low molecular weight polyesters, such as polyethylene terephthalate and polybutylene terephthalate, and mixtures thereof. A preferred film former of the invention is a wax, more preferably Velvetol wax, commercially available from RhonePoulenc.

The coupling agents ofthe invention are typically capable of bonding to the conductive fibers and/or the sheathing materials, preferably at a temperature ranging from about 100 to about 350 °C. The coupling agent may help bond or otherwise couple a film former to the conductive fibers or to the sheathing material. For instance, the coupling agent may, if desired, be chosen to help the film former react or interact with the sheathing material. Suitable coupling-agents; include, but are not limited to, alcohols, amines, esters, ethers, hydrocarbons, siloxanes, silazanes, silanes, lactams, lactones, anhydrides, carbenes, nitrenes, orthoesters, imides, enamines, imines, amides, imides, olefins, functionalized olefins and mixtures thereof. Illustrative coupling agents, include but are not limited to, gamma-aminopropyltriethoxysilane, gamma-methacryloxy-propyltrimethoxysilane and gamma-glycidoxypropyltrimethoxysilane, all of which are commercially available from Witco Chemical Company of Chicago, Illinois. Additionally, in one embodiment of the invention the coupling agents are monomers and/or oligomers, for example, alcohols having 6-50 carbons, alkoxylated alcohols, alkylene carbonates, fatty acid esters, carboxylic acids, and oils. Preferred monomers and/or oligomer coupling agents include, but are not limited to, propoxylated bisphenol-A, ethylene carbonate, bisphenol-A, sorbitan monostearate, castor oil, citric acid, mineral oil, butoxyethylstearate, stearate-capped propyleneglycol fumarate oligomers, and mixtures thereof.

The organic wetting agent is applied to the fibers from a bath. The wetting agent may be in the form of an aqueous emulsion of the wetting agent, a solvent based dispersion of the wetting agent or a substantially, solvent-free, aqueous-free bath containing the organic wetting agent.

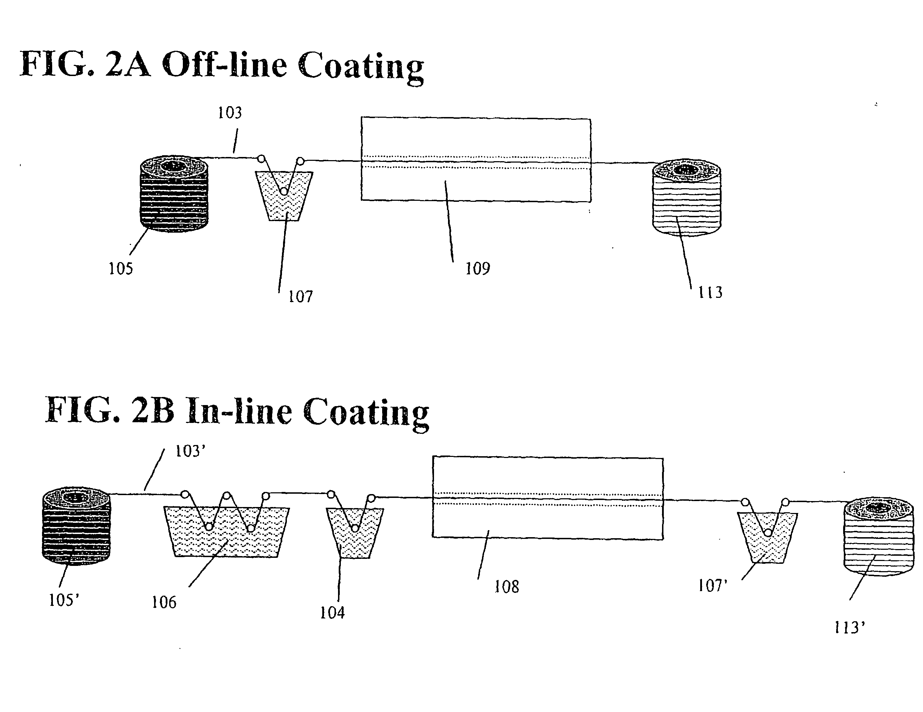

When the organic wetting agent is applied from an aqueous bath as shown in Fig. 2B, the wetting agent may be a solid or a liquid that is dispersed or emulsified in the water. A preferred emulsion of the invention contains water, at least one organic wetting agent, an emulsifier, such as a surfactant, and conventional additives. Any surfactant capable of emulsifying the organic wetting agent in the bath may be employed. Thus, it is contemplated that the surfactant may be selected from anionic, nonionic, cationic, amphoteric and zwitterionic surfactants. Exemplary surfactants include, but are not limited to, Pluronic L101 and Pluronic P105, both of which are commercially available from BASF Corporation.

Thus, in a preferred embodiment of the invention, the aqueous emulsion may contain water, a surfactant and an organic wetting agent wherein the wetting agent is present an amount ranging from about 35 to about 65 weight percent of the bath, more preferably about 45 to about 55 weight percent. Preferred organic wetting agents in the aqueous emulsions include, waxes, nylon, low molecular weight epoxies, polyvinylpyrolidones, aminosilanes such as Dow Coming Z6020 commercially available from Dow Coming.

When the wetting agent is applied from an aqueous bath, it is preferred that a drying step be employed prior to sheathing the fibers. The drying step typically evaporates substantially all of the water on the impregnated fiber tow to avoid trapping large amounts of water in the sheathed tow.

It has been found that, in some instances, the impregnation of too much organic wetting agent on the fiber can adversely affect the mechanical properties of the composites formed from the pellets. Thus, while generally increased quantities of organic wetting agents may result in more thoroughly coated fibers that are more easily dispersed, the mechanical properties of the pellets and the resulting electrically conductive articles may suffer if the amount of the organic wetting agent on the fiber tow is too great. For example, an increased level of organic wetting agent may cause a loss of interfacial bonding in the pellet such that the fibers can slide out of the sheath and become separated. It is also desired that mechanical characteristics of the resulting article, such as strength, flexibility, or color, be dominated by the material used in the sheath. However, if the quantity of organic wetting agent is to high, the mechanical characteristics may be undesirably influenced by those of the organic wetting agent.

Accordingly, in a preferred embodiment of the invention, the organic wetting agent on the electrically conductive fiber tow is less than about 30 weight percent, and more preferably ranges from about 15 to about 25 weight percent based upon the weight of the impregnated tow. Additionally, when measured in terms of the loss on ignition (LOI), the impregnated tow of the invention should exhibit an LOI of greater than 10 percent and less than about 30 percent, more preferably about 15 to about 25 percent.

In addition to having at least 10 % impregnation of the organic wetting agent, it is desired that the fibers be fully impregnated with the organic wetting agent and that the organic wetting agent be evenly distributed throughout each bundle of fibers. Generally, the fibers are considered impregnated when the organic wetting agent is applied such that it substantially fills in the spaces between the fibers when the fibers are formed into a tow.

Generally, the fibers of the invention may be fed to the organic wetting agent bath at any particular speed such that the fibers are impregnated with the organic wetting agent in an amount of at least 10 % by weight of the impregnated fibers. Typically, lower speeds are employed to ensure that the fibers are properly impregnated and that the impregnated coating is substantially dried prior to sheathing the fibers. Accordingly, fibers are passed through the organic wetting agent bath at a relatively slow speed such as 76 cm/s. However, if the fibers are dried in a drying step prior to sheathing, higher speeds may be employed when passing the fibers through the bath. Thus, for example, if a drying oven is used to dry the fibers prior to sheathing, the fibers may be passed through the organic wetting agent bath at higher speeds, such as 76-152 cm/s.

Additionally, if desired, a curing step may be employed to cure or partially cure the organic wetting agent prior to sheathing the impregnated fiber tow.

### Sheathing of Impregnated Tow

Generally, the sheathing of an electrically conductive fiber tow may be accomplished by any conventional means known in the art. For example, the fiber tow may be sheathed by pulling the fiber tow through what has been referred to as a "wire-coating" device. Wire-coating devices typically include an extruder for supplying a molten sheathing material and a die having an entrance orifice, an exit orifice and a coating chamber disposed between. The extruder supplies molten sheathing material to the coating chamber. The strand is coated with the molten material and the coating is formed into a uniform sheathing layer as it is passed through the exit orifice of the die. A suitable wirecoater is the KN200 50.8 mm (2-inch) extruder equipped with a cross-head coating die available from Killion of Cedar Grove, New Jersey.

A preferred wire coater of the invention includes a die, which shapes the sheath to the desired uniform thickness and/or cross-section. For example, sheathed strands may be formed by pulling or otherwise passing the impregnated fiber tow through a corresponding number ofdies, with each die having at least one exit orifice sized to form a sheath material into a sheath of the desired thickness. When using a wire-coating device, the impregnated tow is typically fed or passed through the coating device through the use of a puller. The puller may be separate from or part of the wire coater.

Suitable sheathing materials include thermoplastic and thermosetting materials including those described in WO 98/06551. Preferred sheathing materials for the invention are polymeric materials such as polycarbonate resin (PC), nylon, polybutylene terephthalate (PBT), polyethylene terephthalate (PET), polystyrene.(PS), polyethylene, polypropylene, acrylonitrile butadiene styrene (ABS), polyphenylene sulfide (PPS), polyether ether ketone (PEEK), polyether imide (PEI), thermoplastic elastomers (TPE), thermoplastic olefins (TPO), and mixtures thereof. The preferred sheathing materials are PC/ABS, nylon, and PET.

When selecting the sheathing materials and organic wetting agents, it is preferred that the two materials are compatible with each other. In general, a sheathing material is considered compatible with an organic wetting agent if the two materials are capable of interacting with and/or reacting with each other such that the impregnated fiber tow does not separate from the sheath.

In order to further improve the impregnation during the sheathing process, the impregnated fiber tow may be pre-heated immediately prior to wire-coating. It is presumed that this increases the capillary action of the sheath material such that a greater number of fibers will be wetted. The preheating may be accomplished by resistive heating, electrostatic heating, radiative or convective heating of the fiber tow, with resistive heating being the preferred method. Resistive heating is made possible since the fiber tow is electrically conductive. By passing the strand across metal contact points with a potential voltage difference, it is possible to rapidly heat the strand. Typical voltage between contact points ranges between 3 and 5 Volts at 5 to 20 Amperes.

Preferably, the sheath material forms at least 75 percent by weight of the sheathed fiber. indeed, through the use of the invention, the resulting sheathed tows may contain 5 weight percent conductive fibers, yet still exhibit superior electromagnetic shielding when formed into a composite article. In the preferred embodiment, the sheath material forms 80-95 percent by weight of the sheathed fiber. In the most preferred embodiment, the sheath material forms 85-90 percent by weight of the sheathed fiber.

Once sheathed, the impregnated fiber tow may be cut or otherwise separated into discrete lengths to form a plurality of encased composite pellets or wound or otherwise packaged to form a sheathed composite tow.

### Additives

Conventional additives may be applied in combination with the organic wetting agent or sheathing material or in a separate process such as an additional bath or extruder. Preferably, the conventional additives are added along with the organic wetting agent and the sheathing material.

Suitable additives include those conventional additives known in the art, such as, compatibilizers, viscosity modifiers, lubricants, static reducing agents and processing aids, which are applied to the fibers. More specifically, additives which may be employed in the invention, include, but are not limited to, epoxy-functional viscosity modifiers, butoxyethylstearate, diglycidyl ether of 1,4-butanediol, polyglycidyl ether of castor oil, monomer equivalents of di-n-butyl terephthalate, dibenzoate esters of 1,4-butanediol, diethyl terephthalate, dibenzoate esters of ethylene glycol, caprolactone, adducts of adipoylchloride, n-aminohexane, n-butyl amic acid, adducts of 1,6-hexadiamine, hexanoylchloride, polyvinylpyrrolidone, polyethyleneglycol ester emulsions in mineral oil, polyethylene glycols, polyethylene glycol monostearates and polyethyleneimines.

### Cutting Sheathed Tow into Pellets

The sheathed impregnated fiber tow may be cut into pellets through the use of a chopper. If desired, the chopper may be adapted to also function as a puller or aid a pulling in pulling the impregnated tow through the wire coating device. An exemplary chopper is the commercially available model 204T Chopper manufactured by Conair-Jettro of Bay City, Michigan.

When cutting the sheathed impregnated fiber tows into pellets, the electrically conductive fibers will generally extend the length of the pellet. Thus, the pellet and the fibers contained therein will be of substantially the same length. Generally, the sheathed impregnated fiber tows are cut into pellets of having a length of between about 4mm to about 15mm, more preferably about 6mm to 13mm.

### Composites of the Invention

Composite articles may be made from the sheathed impregnated tows or pellets of the invention. Exemplary composite articles of the invention include, but are not limited to, EMI-shielded composites and conductive plastic mats, fabrics, sheets, panels and filament wound pipes.

As one example of an application for a conductive plastic, an article that has been molded from a plastic that conducts only slightly can be given an electrical charge and can then be painted by electrostatic painting techniques. Another more demanding requirement occurs with composites of the invention when they are formed into conductive plastic enclosures (covers) for electronic apparatus that requires electromagnetic shielding. The cover isolates the apparatus from electromagnetic radiation that could otherwise produce spurious signals in the circuits of unshielded apparatus, and it similarly prevents the apparatus within a shielded cover from transmitting signals to interfere with other nearby apparatus.

It should be recognized that conductive plastic composites of the invention are not conductive to the degree that metal conductors are conductive. Generally, the conductive fibers in a molded article provide conductivity to the extent that they fortuitously touch or very nearly touch. Electrical conduction and electromagnetic shielding may also be attributed to capacitive and inductive coupling between isolated fibers. In an ideal situation, the fibers would have random positions and random orientations so that electrical pathways would extend in three dimensions from each individual fiber. As described above, by employing the organic wetting agent in an amount of about 10 % by weight of the impregnated tow, the dispersion of the fibers in a composite is improved which leads to improved conductivity and electromagnetic shielding properties for the resulting composite.

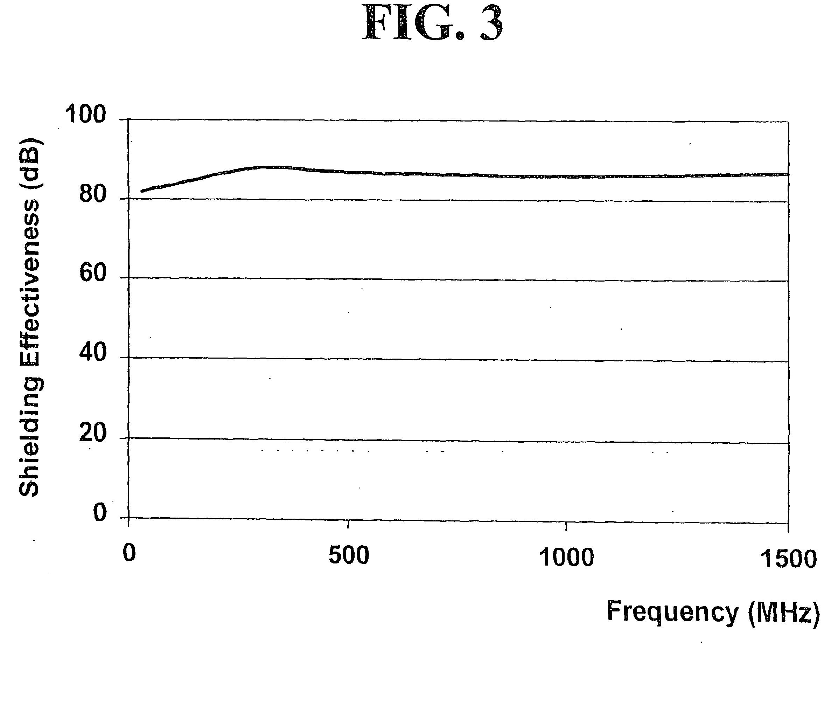

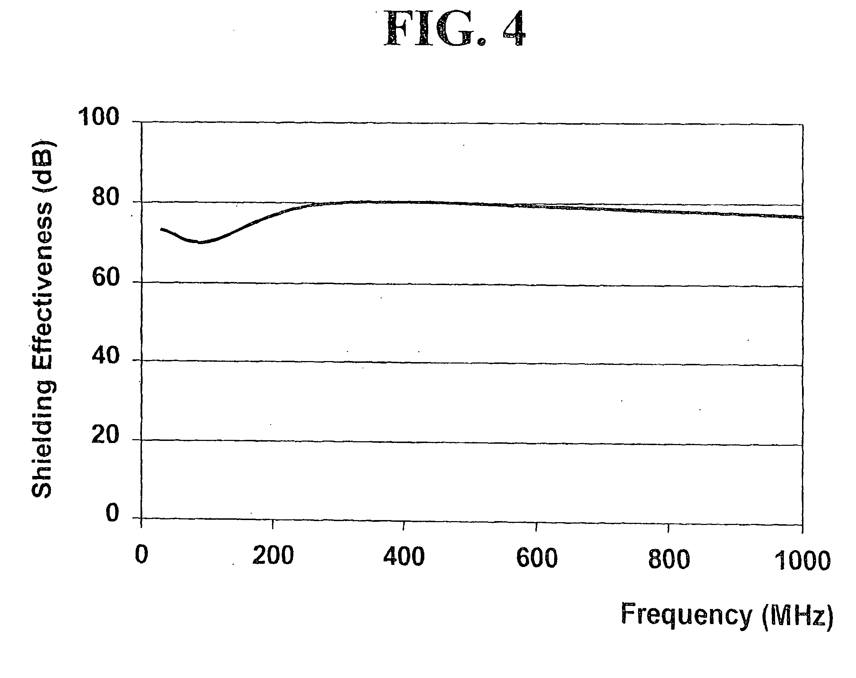

Through the use of the invention, electromagnetically shielded articles may be formed which possess a shielding effectiveness of 80 dB at a frequency of 30-1500 MHz. The shielding effectiveness may be determined by ASTM D4935, which measures far field shielding effectiveness (FIG. 3), or by ASTM ES7-83, which measures near field shielding effectiveness (FIG. 4). The in Figs. 3 and 4 depict EMI performance of flat panels injection molded from wire coated pellets as described in the invention. Both FIG. 3 and FIG. 4 show a material in which a nickel-coated carbon fiber has been impregnated with a polycaprolactone resin and then wire coated with a nylon 6,6 resin. The resulting wire coated pellets and molded plastic contain 15 weight percent loading of conductive fibers. FIG. 3 shows far field shielding effectiveness measured by ASTM test D4935, while FIG. 4 shows near field shielding effectiveness measured by ASTM test ES7-83.

The composite articles of the invention may be formed by conventional means known in the art. For example, one or more of the sheathed tows or pellets may be processed together to form all or part of the matrix of a composite article. Suitable processes include mixing and molding, e.g., injection molding and compression molding. Furthermore, for foamed composite articles, the pellets of the invention may be molded in the presence of an appropriate amount of a blowing agent.

Depending upon the desired properties of the composite article, it may be beneficial to incorporate powders, flakes or additional cut fibers, such as reinforcement fibers, when mixing the sheathed tows or pellets of the invention. For example, pellets containing the sheathed impregnated tows of the invention could be mixed with pellets containing sheathed and impregnated nonconductive fibers.

Suitable reinforcement fibers include, but are not limited to, glass materials such as borosilicate glass, glass wool, rock wool, slag wool and mineral wool, as well as non-glass materials such as carbon, graphite, silicon carbide and Kevlar®.

Suitable flakes may be made from metal particles, for example, silver, aluminum, copper or nickel or alloys thereof. The flakes may be in a variety of shapes, for instance a flat or oval.

Suitable powders include, but are not limited to, conductive and semi-conductive powders. For example, the powders may be selected from zinc oxides, zinc sulfides, cadmium sulfides, lead sulfide, manganese oxides, tin oxides, indium oxides and nickel oxides. The average size of such powders can range from about 0.1 micrometers to about 50 micrometers, preferably about 0.1 to about 25 micrometers, most preferably about 0.2 to about 4 micrometers.

The method for forming electrically conductive impregnated fibers and pellets having the same will now be described with reference to FIGS. 2A and 2B.

FIG. 2A shows a process schematic for forming electrically conductive impregnated fibers using an off-line application of the organic wetting agent. As shown in FIG. 2A, the electrically conductive fiber tow 103 is unwound from a package or spool 105. The electrically conductive fiber tow 103 may be pulled using a puller (not shown). The electrically conductive fiber tow 103 includes a plurality of electrically conductive fibers. These conductive fibers may be formed from a nonconductive substrate fiber, which is unwound and coated with a metal, by aqueous electroplating or the like.

The electrically conductive fiber tow 103 is pulled through a bath 107 to apply an organic wetting agent Accordingly, the organic wetting agent will penetrate the electrically conductive fiber tow 103 such that the electrically conductive fiber tow 103 is impregnated with the organic wetting agent and the fibers of the electrically conductive fiber tow 103 are coated. In a preferred embodiment, the sizing bath 107 applies coupling agents, film formers, and mixtures thereof to the electrically conductive fiber tow 103. The bath 107 may be aqueous or nonaqueous, and in the event that the bath is a nonaqueous solution, the process preferably does not require a drying oven prior to being spooled as described below.

When an aqueous size is used in the bath 107, the impregnated electrically conductive fiber tow 103 is then pulled through a drying oven 109 to dry the electrically conductive fiber tow 103. For example, if an aqueous emulsion is used in the sizing bath 107, it may be desired to drive off the water content through the use of a drying oven. The impregnated electrically conductive fiber tow 103 may then be wound onto a package (or spool) 113.

The impregnated electrically conductive fiber tow 103 is then fed into a wire coating die (not shown) from the package 113. Within the die, a thermoplastic or thermoset sheath is formed around the strand to encapsulate the electrically conductive fiber tow 103 with the electrically conductive fiber tow 103 forming the core of the sheathed tow. Neither preheating of the strand nor breaker bars within the die is required. That is, sheathing materials, such as thermoplastics or thermosets are easily applied as a sheath around the electrically conductive fiber tow 103. The sheathed tow can then be wound onto another package, such as a spool (not shown).

Next, the sheathed tow can then be unwound and provided to a chopper (not shown) to chop the sheathed tow into pellets of desired lengths. Alternatively, the impregnated electrically conductive fiber tow 103 can be fed into the wire coating die to apply the sheath in-line without being wound. Furthermore, the sheathed electrically conductive fiber tow 103 can provided to the chopper without being wound to chop the sheathed tow 103 into pellets in-line.

In an in-line process according to the present invention, as shown in Fig. 2B, a fiber tow 103' is unwound from a package or spool 105' and drawn through an aqueous silane bath 106 to apply a conductive coating to the tow 103'. The tow 103' is then drawn through an aqueous silane bath 104 and through an oven 108. The tow 103' then passes though a nonaqueous sizing bath 107' (or which may alternatively be applied with rolling applicator - not shown). After this step according to this invention, the tow 103' typically does not require a drying step due to no water having been added in the size bath 107'. The tow 103' is then wound onto a package (or spool) 113'. Alternatives to the in-line process shown in FIG. 2B include the use of a single bath, and thus elimination of either 104 or 107'show in FIG. 2B. Furthermore, if all coating applications used (106 and 104 and/or 107') are nonaqueous, the oven 108 may not be required, as such a nonaqueous process would not require that one drive off any water content through the use of such a drying oven.

A preferable nonaqueous size consists of any of a family of paraffin waxes, polycaprolactones, low molecular weight epoxies, polyethylene glycol, or any of a number of types of low melting film formers. These sizes, applied at sufficiently high organic concentration onto the strand will allow the strand to disperse after wire coating and injection molding. A preferred nonaqueous application of the conductive metal coating comprises a gaseous Chemical Vapor Deposition process, as known to one skilled in the art.

FIGS. 3 and 4 illustrate the superior results obtained with electrically conductive fibers prewet with the high levels of organic wetting agent according to the invention. FIG. 3 shows far field shielding effectiveness (ASTM D4935) for injection molded flat panels, the shielding based on 15% nickel coated fibers, wherein the fibers were pre-impregnated with polycaprolactone, then wire coated with nylon 6,6. FIG. 4 shows near field shielding effectiveness (ASTM ES7-83) for panels similar to those tested for FIG. 3. Typical compounding at 15% loading would be only about 15-25 dB, whereas as shown in FIGS. 3 and 4, we achieved 70-90 dB using the present invention.

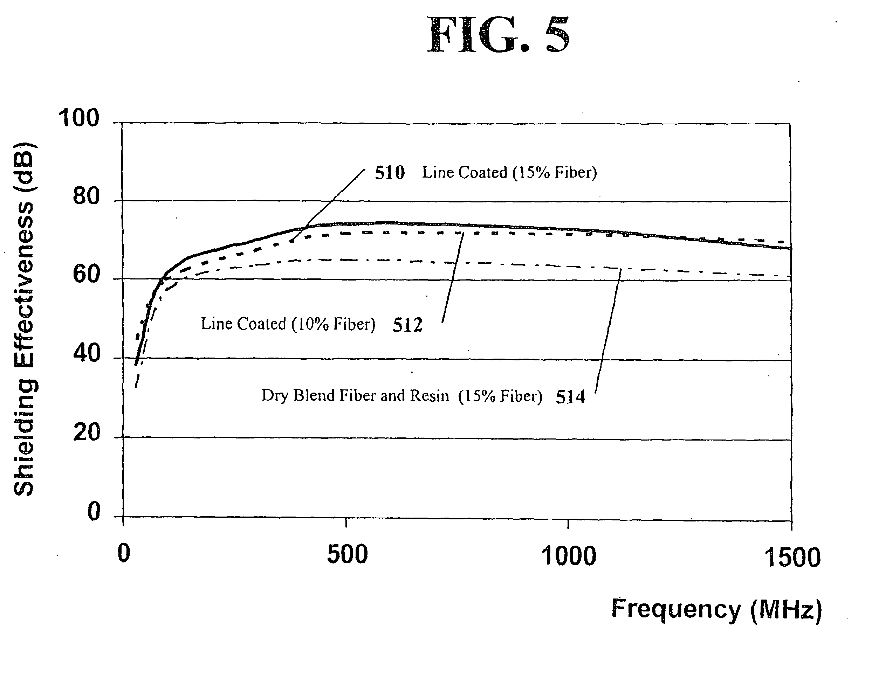

FIG. 5 illustrates the shielding effectiveness of PC/ABS Plaques (ASTM D4935), demonstrating the improved EMI shielding performance obtained with thermoplastic molded articles having fibers formed according to the present invention as compared with articles having conventional fibers, in which the fibers and resin are combined by dry blending. For the wire coated (sheathed fibers), the shielding effectiveness has been evaluated for both 15% and 10% nickel-coated carbon fibers sheathed in PC/ABS resin (Cycoloy C6200) from GE Plastics, illustrated in FIG. 5 as lines 510 and 512, respectively. The pellets according to the present invention are about 6.35 mm (0.25 inches) long. Accordingly, the electrically conductive fibers are also about 6.35 mm (0.25 inches) long. These electrically conductive fibers have been respectively impregnated with Velvetol wax emulsion from RhonePoulenc (50%), Neoxil 954D polyester emulsion from DSM (25%), and AD502 epoxy emulsion from Owens Coming (25%). For comparison, the shielding effectiveness obtained by molding articles from pellets having uncoated fibers (with lengths of 6.35 mm (0.25 inches)) and dry blended with PC/ABS resin are also illustrated in FIG. 5 at the line indicated as 514. As can be seen, the articles manufactured from fibers or pellets according to the present invention provide increased shielding effectiveness.

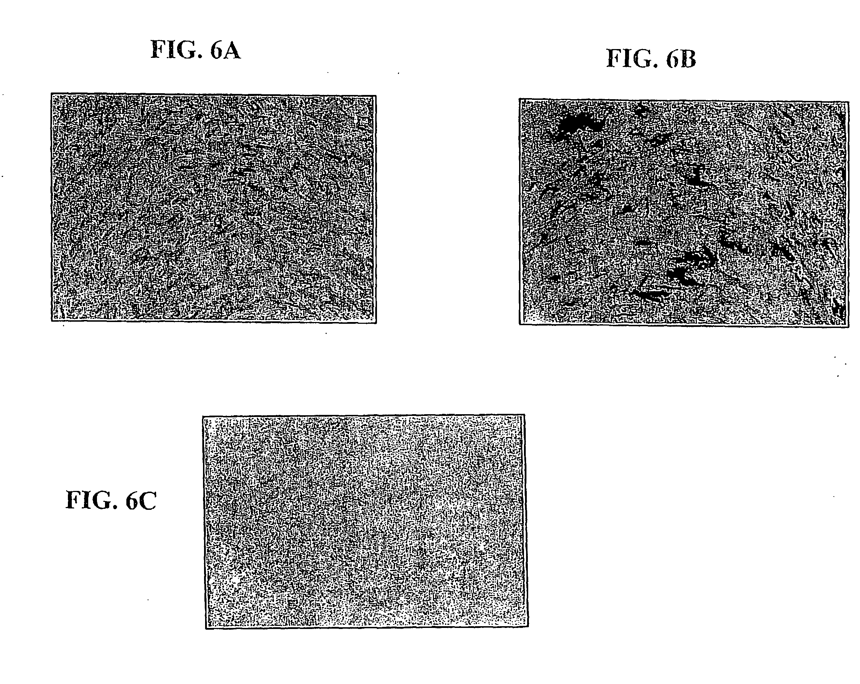

FIGS. 6A, 6B and 6C provide visual evidence to explain how the present invention enables more effective electrical conductivity to be imparted to the molded composite. In these FIGS. 6A-6C, 3nnm thick PC/ABS plaques have been molded by three different techniques and then x-rayed to examine the relative location of the conductive fibers. In FIG. 6A, fibers are dry-blended with resin and then injection molded. Since the fibers are not pre-impregnated, they do not adequately disperse in the molded part appearing as bundles of fibers, typically remaining in clusters of 500-2000 fibers. Consequently, a conductive network of fibers is not established within the part, and non-wetted fibers can be observed at the surface of the part. In FIG. 6B, fibers have been pre-impregnated, but the pre-impregnation coating has only modestly improved the dispersion of fibers during the molding process, as the sizing was not optimized in this example. In FIG. 6C, the conductive fibers have been properly pre-impregnated [Velvetol wax emulsion from RhonePoulenc (50%), Neoxil 954D polyester emulsion from DSM (25%), and AD502 epoxy emulsion from Owens Coming (25%)] and then sheathed with PC/ABS. The sheathed fibers of FIG. 6C disperse exceptionally well, thereby enabling a conductive fiber network to develop throughout the part.

The foregoing detailed description has been given for clearness of understanding only and no unnecessary limitations should be understood therefrom as modifications will be obvious to those skilled in the art.

The present invention provides a number of advantages, including the electrically conductive fibers are easily dispersed in the molding process. By employing an organic wetting agent in an amount of at least 10% by weight of an impregnated tow, the electrically conductive fibers are wetted and more apt to completely and randomly disperse during the molding process. Thus, when an article is formed from the pellets of the present invention, the electrically conductive fibers create a fully integrated electrically conductive network within the plastic. As a result, superior static dissipative behavior, electromagnetic shielding, and other electrical characteristics are obtained. In contrast, electrically conductive fibers that are not prewetted tend to remain in bundles rather than dispersing. Such undispersed bundles may result in unacceptable aesthetics and reduced electromagnetic shielding properties.

Additional advantages include uniform weight fraction of electrically conductive fiber to thermoplastic (or thermoset) is obtained in pellets manufactured by the method of the present invention because each pellet includes an electrically conductive fiber tow segment extending the length of the pellet. Thus, there is uniform fiber loading within each batch of pellets. In contrast, conventional techniques simply dry blend long fibers with thermoplastic pellets. As a result, the conventional dry blended fibers tend to segregate from the pellets so that the fiber loading may become inconsistent.

### EXAMPLES

A wide variety of compounds have been produced using the present invention. Several representative samples are illustrated in the table below. All samples were manufactured using a multi-layer metal coated conductive fiber (nickel-copper-nickel coated carbon). Various impregnation coatings were utilized in order to optimize the impregnation, fiber adhesion, dispersion, surface appearance, and electrical properties. Shielding effectiveness was quantified according to ASTM D4935.

| Impregnation Step | | | Sheathing Step | | | Molded Plaque |
|---|---|---|---|---|---|---|
| Impregnation Coating | LOI (%) | Strand Temp (°F) | Resin | Pellet length (in) | Fiber loading (%) | Shielding Effectiveness at 1000 MHz (dB) |
| Velvetol wax (50%) Neoxil 954D (25%) AD502 (25%) | 16.6 | 75 | PC/ABS¹ | 0.25 | 15 | 73 |
| Polycaprolactone(100%) | 19.1 | 75 | Nylon² | 0.25 | 15 | 86 |
| Velvetol wax (100%) | 18 | 200 | PET³ | 0.25 | 15 | 87 |
| Velvetol wax (66%) Neoxil 954D (17%) AD502 (17%) | 18 | 75 | PS⁴ | 0.38 | 15 | 61 |

| | | | | | | |
|---|---|---|---|---|---|---|
| ¹Cycoloy C6200 commercially available from GE Plastics. | | | | | | |
| ²Zytel 101 commercially available from DuPont. | | | | | | |
| ³Rynite 415HP commercially available from DuPont. | | | | | | |
| ⁴Hunstman 331 commercially available from Huntsman Chemical. | | | | | | |

As illustrated in the foregoing examples, excellent shielding was obtained for all of the compounds. In general, shielding effectiveness exceeding 60dB is considered suitable for use as a conductive shield on most electronics.

While the invention has been described in connection with specific embodiments regarding the method for forming electrically impregnated fibers and the fibers themselves, it will be understood that the invention is capable of further modifications and this application is intended to cover any variations, uses, or adaptations of the invention which come within the scope of the appended claims.

## Claims

1. A method for forming electrically conductive impregnated fibers, comprising the steps of:
(a) feeding electrically conductive fibers (105, 105') through a bath (107, 107') containing an organic wetting agent to impregnate the fibers with the organic wetting agent forming an impregnated fiber tow (103, 103'); and
(b) applying a thermoplastic or thermoset sheath onto the impregnated fiber tow (103, 103') to form a sheathed, impregnated fiber tow,
the method being **characterized in that**:
the organic wetting agent impregnated in step (a) is at least 10 percent by weight of the resulting impregnated fiber tow.

2. The method according to claim 1, further comprising the step of:
(c) cutting the sheathed impregnated fiber tow into pellets.

3. The method according to claim 2, further comprising the steps of:
(d) introducing the pellets into a mold; and
(e) melting the pellets in the mold to form an electro-magnetic shielding composite, wherein the organic wetting agent enables the even distribution of the fibers in the composite.

4. The method according to claim 1, further comprising, prior to step (a), the steps of:
(i) feeding out non-electrically conductive fibers (105'); and
(ii) applying an electrically conductive coating (106) to the non-electrically conductive fibers (105').

5. The method according to claim 4, wherein step (a)(ii) applying the electrically conductive coating (106), comprises electroplating non-electrically conductive carbon fibers with a metal coating.

6. The method according to claim 1, wherein step (a) is performed in-line.

7. The method according to claim 1, wherein the electrically conductive fibers (105, 105') of step (a) are fed out at a speed of less than about76 cm/s.

8. The method according to claim 1, wherein impregnation step (a) comprises pulling the electrically conductive fibers (105, 105') through a bath (107, 107') containing the organic wetting agent.

9. The method according to claim 1, wherein the organic wetting agent is selected from the group consisting of coupling agents, film formers and mixtures thereof.

10. The method according to claim 9, wherein the organic wetting agent includes a film former selected from the group consisting of waxes, polyethylene glycols, polypropylene glycols, polycaprolactones, glycidyl ethers, epoxy resins, urethanes, polyester alkyds, amic acid, propylene glycol fumarate, propoxylated bisphenol-A-maleate, propoxylated allyl alcohol-maleate, polyvinyl acetates, olefins, low molecular weight polyesters and mixtures thereof, wherein the film former is capable or coating the individual electrically conductive fibers to form an impregnated tow.

11. The method according to claim 9, wherein the organic wetting agent includes a coupling agent selected from the group consisting of alcohols, amines, esters, ethers, hydrocarbons, siloxanes, silazancs, silanes, lactams, lactones, anhydrides, carbenes, nitrenes, orthoesters, imides, enamines, imines, amides, imides, functionalized olefins and mixtures thereof, wherein the coupling agent is capable of bonding the conductive fibers to the thermoplastic or thermoset sheath at a temperature ranging from about 100 to about 300 °C.

12. The method according to claim 8, wherein the bath (107, 107') is an aqueous emulsion of the wetting agent.

13. The method according to claim 1, wherein the impregnation step (a) comprises pulling the electrically conductive fiber through a nonaqueous bath (107, 107') containing the organic wetting agent and directly feeding the impregnated fiber tow to sheathing step (b).

14. The method according to claim 1, wherein the sheathing of the impregnated fiber tow is performed in-line with the impregnation step (a).

15. The method according to claim 2, wherein prior to cutting step (c) the sheathed electrically conductive fiber tow is wound into a package (113, 113').

16. The method according to claim 2, wherein cutting step (c) is performed in-line with the sheathing of the impregnated fiber tow.

17. The method according to claim 2, wherein cutting step (c) comprises cutting the fiber tow into pellets having a length ranging from about 6 mm to about 13 mm.

18. The method according to claim 2, wherein the electrically conductive fiber tow is substantially on an axis of the pellet and extends the length of the pellet.

19. The method according to claim 1, wherein the organic wetting agent forms between 10 and 30 percent by weight of the impregnated fiber tow.

20. The method according to claim 1, wherein the organic wetting agent forms between 15 and 25 percent by weight of the impregnated fiber tow.

21. The method according to claim 1 further **characterized in that**:
the organic wetting agent is an aqueous emulsion of about 35-65 weight percent wax, and
wherein the wax is present on the fibers in an amount ranging from about 10 to about 30 percent by weight of the resulting impregnated fiber tow.

22. The method according to claim 21, wherein the sheath is a thermoplastic selected from the group consisting of polycarbonate resin, nylon, polybutylene terephthalate, polyethylene terephthalate, polystyrene, polypropylene, acrylontrile butadiene styrene, polyphenylene sulfide, polyether ether ketone, polyether imide, thermoplastic olefins, elastomers, and mixtures thereof, and the conductive fibers are present in the pellets in an amount of less than about 25 weight percent.

23. The method according to claim 21 wherein the impregnated fiber tow is pre-heated immediately prior to sheathing to facilitate impregnation by the sheath material.

24. The method according to claim 23 wherein the impregnated fiber tow is pre-heated using resistive heating.

25. The method according to claim 1, wherein the coating comprises an organic material having a viscosity, at a temperature range of 80 °C - 180 °C, no greater that 1.5 Pa-s.

26. The method of claim 25 wherein the viscosity of the organic material at a temperature range of 80 °C -180 °C is no greater than 0.8 Pa-s.

27. The method of claim 25 wherein the viscosity of the organic material at a temperature range of 80 °C - 180 °C is no greater than 0.4 Pa-s.

28. The method of claim 25 wherein the viscosity of the organic material at a temperature range of 80 °C - 180 °C is no greater than 0.2 Pa-s.

29. The method of claim 25 wherein the viscosity of the organic material at a temperature range of 80 °C - 180 °C is no greater than 0.075 Pa-s.

30. The method of claim 25 wherein the viscosity of the organic material at a temperature range of 80 °C - 180 °C is no greater than 0.025 Pa-s.

31. The method of claim 25 wherein the viscosity of the organic material at a temperature range of 80 °C - 180 °C is no greater than 0.005 Pa·s.

## Patentansprüche

1. Verfahren zur Herstellung von elektrisch leitenden imprägnierten Fasern, wobei das Verfahren folgende Schritte umfasst:
(a) Führen von elektrisch leitenden Fasern (105, 105') durch ein Bad (107, 107'), welches ein organisches Benetzungsmittel enthält, um die Fasern mit dem organischen Benetzungsmittel zu imprägnieren, wodurch ein imprägniertes Faserwerg (103, 103') gebildet wird; und
(b) Auftragen einer thermoplastischen oder wärmehärtbaren Ummantelung auf das imprägnierte Faserwerg (103, 103'), um ein ummanteltes, imprägniertes Faserwerg zu bilden, wobei das Verfahren **dadurch gekennzeichnet ist, dass** das organische Benetzungsmittel, das in Schritt (a) imprägniert wird, mindestens 10 Gewichtsprozent des resultierenden imprägnierten Faserwergs ausmacht.

2. Verfahren nach Anspruch 1, welches ferner folgenden Schritt umfasst: (c) Schneiden des ummantelten imprägnierten Faserwergs in Pellets.

3. Verfahren nach Anspruch 2, welches ferner folgende Schritte umfasst:
(d) Einführen der Pellets in eine Form; und
(e) Schmelzen der Pellets in der Form, um einen elektromagnetisch abschirmenden Verbundstoff zu bilden, wobei das organische Benetzungsmittel die gleichmäßige Verteilung der Fasern in dem Verbundstoff ermöglicht.

4. Verfahren nach Anspruch 1, welches ferner vor dem Schritt (a) folgende Schritte umfasst:
(i) Abziehen von nicht elektrisch leitenden Fasern (105') und
(ii) Auftragen einer elektrisch leitenden Beschichtung (106) auf die nicht elektrisch leitenden Fasern (105') .

5. Verfahren nach Anspruch 4, wobei Schritt (a) (ii), Auftragen der elektrisch leitenden Beschichtung (106), das Elektroplattieren von nicht elektrisch leitenden Kohlenstofffasern mit einer Metallbeschichtung umfasst.

6. Verfahren nach Anspruch 1, wobei Schritt (a) in Linie ausgeführt wird.

7. Verfahren nach Anspruch 1, wobei die elektrisch leitenden Fasern (105, 105') von Schritt (a) mit einer Geschwindigkeit von weniger als ungefähr 76 cm/s abgezogen werden.

8. Verfahren nach Anspruch 1, wobei der Imprägnierungsschritt (a) das Ziehen der elektrisch leitenden Fasern (105, 105') durch ein Bad (107, 107') umfasst, welches das organische Benetzungsmittel enthält.

9. Verfahren nach Anspruch 1, wobei das organische Benetzungsmittel aus der Gruppe bestehend aus Haftmitteln, Filmbildnern und Mischungen davon ausgewählt ist.

10. Verfahren nach Anspruch 9, wobei das organische Benetzungsmittel einen Filmbildner enthält, der aus der Gruppe ausgewählt ist, die aus Wachsen, Polyethylenglykolen, Polypropylenglykolen, Polycaprolactonen, Glycidylethern, Epoxidharzen, Urethanen, Polyesteralkyden, Säureamid, Propylenglykolfumarat, propoxyliertem Bisphenol-A-Maleat, propoxyliertem Allylalkoholmaleat, Polyvinylacetaten, Olefinen, Polyestern mit niedrigem Molekulargewicht und Mischungen davon besteht, wobei der Filmbildner in der Lage ist, die einzelnen elektrisch leitenden Fasern zu beschichten, um ein imprägniertes Spinnkabel zu bilden.

11. Verfahren nach Anspruch 9, wobei das organische Benetzungsmittel ein Haftmittel enthält, das aus der Gruppe ausgewählt ist, die aus Alkoholen, Aminen, Estern, Ethern, Kohlenwasserstoffen, Siloxanen, Silazanen, Silanen, Lactamen, Lactonen, Anhydriden, Carbenen, Nitrenen, Orthoestern, Imiden, Enaminen, Iminen, Amiden, Imiden, funktionalisierten Olefinen und Mischungen davon besteht, wobei das Haftmittel in der Lage ist, die leitenden Fasern an die thermoplastische oder wärmehärtbare Ummantelung bei einer Temperatur im Bereich von ungefähr 100 bis ungefähr 300 °C zu binden.

12. Verfahren nach Anspruch 8, wobei das Bad (107, 107') eine wässerige Emulsion des Benetzungsmittels ist.

13. Verfahren nach Anspruch 1, wobei der Imprägnierungsschritt (a) das Ziehen der elektrisch leitenden Faser durch ein nicht wässeriges Bad (107, 107'), welches das organische Benetzungsmittel enthält, und das direkte Zuführen des imprägnierten Faserwergs zum Ummantelungsschritt (b) umfasst.

14. Verfahren nach Anspruch 1, wobei die Ummantelung des imprägnierten Faserwergs in Linie mit dem Imprägnierungsschritt (a) erfolgt.

15. Verfahren nach Anspruch 2, wobei vor dem Schneideschritt (c) das ummantelte elektrisch leitende Faserwerg in eine Packung (113, 113') gewickelt wird.

16. Verfahren nach Anspruch 2, wobei der Schneideschritt (c) in Linie mit der Ummantelung des imprägnierten Faserwergs erfolgt.

17. Verfahren nach Anspruch 2, wobei der Schneideschritt (c) das Schneiden des Faserwergs in Pellets mit einer Länge im Bereich von ungefähr 6 mm bis ungefähr 13 mm umfasst.

18. Verfahren nach Anspruch 2, wobei das elektrisch leitende Faserwerg sich im Wesentlichen auf einer Achse des Pellets befindet und die Länge des Pellets erweitert.

19. Verfahren nach Anspruch 1, wobei das organische Benetzungsmittel zwischen 10 und 30 Gewichtsprozent des imprägnierten Faserwergs ausmacht.

20. Verfahren nach Anspruch 1, wobei das organische Benetzungsmittel zwischen 15 und 25 Gewichtsprozent des imprägnierten Faserwergs ausmacht.

21. Verfahren nach Anspruch 1, welches ferner **dadurch gekennzeichnet ist, dass** das organische Benetzungsmittel eine wässerige Emulsion aus ungefähr 35 bis 65 Gewichtsprozent Wachs ist und wobei das Wachs auf den Fasern in einer Menge zwischen ungefähr 10 bis ungefähr 30 Gewichtsprozent des resultierenden imprägnierten Faserwergs vorhanden ist.

22. Verfahren nach Anspruch 21, wobei die Ummantelung ein thermoplastisches Material ist, das aus der Gruppe ausgewählt ist, die aus Polycarbonatharz, Nylon, Polybutylenterephthalat, Polyethylenterephthalat, Polystyrol, Polypropylen, Acrylontrilbutadienstyrol, Polyphenylensulfid, Polyetheretherketon, Polyetherimid, thermoplastischen Olefinen, Elastomeren und Mischungen davon besteht, und wobei die leitenden Fasern in den Pellets in einer Menge von weniger als ungefähr 25 Gewichtsprozent vorhanden sind.

23. Verfahren nach Anspruch 21, wobei das imprägnierte Faserwerg unmittelbar vor dem Ummanteln vorerwärmt wird, um das Imprägnieren durch das Ummantelungsmaterial zu erleichtern.

24. Verfahren nach Anspruch 23, wobei das imprägnierte Faserwerg unter Anwendung von Widerstandserwärmung vorerwärmt wird.

25. Verfahren nach Anspruch 1, wobei die Beschichtung ein organisches Material umfasst, das bei einem Temperaturbereich von 80 °C bis 180 °C eine Viskosität aufweist, die nicht größer als 1,5 Pa-s ist.

26. Verfahren nach Anspruch 25, wobei die Viskosität des organischen Materials bei einem Temperaturbereich von 80 °C bis 180 °C nicht größer als 0,8 Pa-s ist.

27. Verfahren nach Anspruch 25, wobei die Viskosität des organischen Materials bei einem Temperaturbereich von 80 °C bis 180 °C nicht größer als 0,4 Pa-s ist.

28. Verfahren nach Anspruch 25, wobei die Viskosität des organischen Materials bei einem Temperaturbereich von 80 °C bis 180 °C nicht größer als 0,2 Pa-s ist.

29. Verfahren nach Anspruch 25, wobei die Viskosität des organischen Materials bei einem Temperaturbereich von 80 °C bis 180 °C nicht größer als 0,075 Pa-s ist.

30. Verfahren nach Anspruch 25, wobei die Viskosität des organischen Materials bei einem Temperaturbereich von 80 °C bis 180 °C nicht größer als 0,025 Pa-s ist.

31. Verfahren nach Anspruch 25, wobei die Viskosität des organischen Materials bei einem Temperaturbereich von 80 °C bis 180 °C nicht größer als 0,005 Pa-s ist.

## Revendications

1. Procédé pour former des fibres imprégnées électriquement conductrices, comprenant les étapes consistant à :
(a) alimenter les fibres électriquement conductrices (105, 105') au moyen d'un bain (107, 107') contenant un agent mouillant organique afin d'imprégner les fibres avec l'agent mouillant organique en formant une étoupe imprégnée (103, 103') ; et
(b) appliquer une gaine thermoplastique ou thermodurcissable sur l'étoupe imprégnée (103, 103') pour former une étoupe imprégnée gainée,
ledit procédé étant **caractérisé en ce que** :
l'agent mouillant organique imprégné dans l'étape (a) représente au moins 10 pour cent en poids de l'étoupe imprégnée ainsi obtenue.

2. Procédé selon la revendication 1, comprenant en plus l'étape consistant à :
(c) découper l'étoupe imprégnée gainée en granulés.

3. Procédé selon la revendication 2, comprenant en plus les étapes consistant à :
(d) introduire les granulés dans un moule ; et
(e) faire fondre les granulés dans le moule afin de former un composite de blindage électromagnétique, dans lequel l'agent mouillant organique permet la distribution uniforme des fibres dans le composite.

4. Procédé selon la revendication 1, comprenant en plus, avant l'étape (a), les étapes consistant à :
(i) alimenter des fibres électriquement non conductrices (105') ; et
(ii) appliquer un revêtement électriquement conducteur (106) sur les fibres électriquement non conductrices (105').

5. Procédé selon la revendication 4, dans lequel l'étape (a) (ii) d'application du revêtement électriquement conducteur (106) comprend l'électrodéposition d'un revêtement métallique sur des fibres de carbone électriquement non conductrices.

6. Procédé selon la revendication 1, dans lequel l'étape (a) s'effectue en ligne.

7. Procédé selon la revendication 1, dans lequel les fibres électriquement conductrices (105, 105') de l'étape (a) sont alimentées à une vitesse inférieure à environ 76 cm/s.

8. Procédé selon la revendication 1, dans lequel l'étape d'imprégnation (a) comprend le tirage des fibres électriquement conductrices (105, 105') au moyen d'un bain (107, 107') contenant l'agent mouillant organique.

9. Procédé selon la revendication 1, dans lequel l'agent mouillant organique est choisi dans le groupe constitué par des agents de couplage, des agents filmogènes et des mélanges de ceux-ci.

10. Procédé selon la revendication 9, dans lequel l'agent mouillant organique comprend un agent filmogène choisi dans le groupe constitué par des cires, des polyéthylènes glycols, des polypropylènes glycols, des polycaprolactones, des éthers de glycidyle, des résines époxydes, des uréthanes, des polyester alkydes, l'acide amique, le fumarate de propylène glycol, le maléate de bisphénol-A propoxylé, le maléate d'alcool allylique propoxylé, des polyacétates de vinyle, des oléfines, des polyesters de faible masse moléculaire et des mélanges de ceux-ci, dans lequel l'agent filmogène est capable de revêtir les fibres individuelles électriquement conductrices afin de former une étoupe imprégnée.

11. Procédé selon la revendication 9, dans lequel l'agent mouillant organique comprend un agent de couplage choisi dans le groupe constitué par des alcools, des amines, des esters, des éthers, des hydrocarbures, des siloxanes, des silazanes, des silanes, des lactames, des lactones, des anhydrides, des carbènes, des nitrènes, des orthoesters, des imides, des énamines, des imines, des amides, des imides, des oléfines fonctionnalisées et des mélanges de ceux-ci, dans lequel l'agent de couplage est capable de lier les fibres conductrices à la gaine thermoplastique ou thermodurcissable à une température dans la plage d'environ 100 à environ 300°C.

12. Procédé selon la revendication 8, dans lequel le bain (107, 107') est une émulsion aqueuse de l'agent mouillant.

13. Procédé selon la revendication 1, dans lequel l'étape d'imprégnation (a) comprend le tirage de la fibre électriquement conductrice au moyen d'un bain non aqueux (107,107') contenant l'agent mouillant organique et l'alimentation directe de l'étoupe imprégnée dans l'étape de gainage (b).

14. Procédé selon la revendication 1, dans lequel le gainage de l'étoupe imprégnée s'effectue en ligne avec l'étape d'imprégnation (a).

15. Procédé selon la revendication 2, dans lequel, avant l'étape de découpe (c), l'étoupe électriquement conductrice gainée est enveloppée dans un emballage (113, 113').

16. Procédé selon la revendication 2, dans lequel l'étape de découpe (c) s'effectue en ligne avec le gainage de l'étoupe imprégnée.

17. Procédé selon la revendication 2, dans lequel l'étape de découpe (c) comprend la découpe de l'étoupe en granulés ayant une longueur dans la plage d'environ 6 mm à environ 13 mm.

18. Procédé selon la revendication 2, dans lequel l'étoupe électriquement conductrice se trouve pratiquement sur un axe du granulé et étend la longueur du granulé.

19. Procédé selon la revendication 1, dans lequel l'agent mouillant organique forme entre 10 et 30 pour cent en poids de l'étoupe imprégnée.

20. Procédé selon la revendication 1, dans lequel l'agent mouillant organique forme entre 15 et 25 pour cent en poids de l'étoupe imprégnée.

21. Procédé selon la revendication 1, caractérisé en plus en ce que :
l'agent mouillant organique est une émulsion aqueuse d'environ 35 à 65 pour cent en poids de cire, et
dans lequel la cire est présente sur les fibres en une quantité dans la plage d'environ 10 à environ 30 pour cent en poids de l'étoupe imprégnée ainsi obtenue.

22. Procédé selon la revendication 21, dans lequel la gaine est un thermoplastique choisi dans le groupe constitué par une résine de polycarbonate, un nylon, le polytéréphtalate de butylène, le polytéréphtalate d'éthylène, le polystyrène, le polypropylène, l'acrylonitrile butadiène styrène, le polysulfure de phénylène, la polyéther éther cétone, le polyéther imide, des oléfines thermoplastiques, des élastomères et des mélanges de ceux-ci, et les fibres conductrices sont présentes dans les granulés en une quantité inférieure à environ 25 pour cent en poids.

23. Procédé selon la revendication 21, dans lequel l'étoupe imprégnée est préchauffée immédiatement avant le gainage afin de faciliter l'imprégnation par le matériau de la gaine.

24. Procédé selon la revendication 23, dans lequel l'étoupe imprégnée est préchauffée en utilisant le chauffage résistif.

25. Procédé selon la revendication 1, dans lequel le revêtement comprend un matériau organique ayant une viscosité non supérieure à 1,5 Pa·s dans une plage de température de 80°C à 180°C.

26. Procédé selon la revendication 25, dans lequel la viscosité du matériau organique n'est pas supérieure à 0,8 Pa·s dans une plage de température de 80°C à 180°C.

27. Procédé selon la revendication 25, dans lequel la viscosité du matériau organique n'est pas supérieure à 0,4 Pa·s dans une plage de température de 80°C à 180°C.

28. Procédé selon la revendication 25, dans lequel la viscosité du matériau organique n'est pas supérieure à 0,2 Pa·s dans une plage de température de 80°C à 180°C.

29. Procédé selon la revendication 25, dans lequel la viscosité du matériau organique n'est pas supérieure à 0,075 Pas dans une plage de température de 80°C à 180°C.

30. Procédé selon la revendication 25, dans lequel la viscosité du matériau organique n'est pas supérieure à 0,025 Pas dans une plage de température de 80°C à 180°C.

31. Procédé selon la revendication 25, dans lequel la viscosité du matériau organique n'est pas supérieure à 0,005 Pas dans une plage de température de 80°C à 180°C.
